Europäisches Patentamt

(19) European Patent Office

Office européen des brevets

(11) Numéro de publication : **0 025 380**
**B1**

(12) **FASCICULE DE BREVET EUROPÉEN**

(45) Date de publication du fascicule du brevet :
**13.06.84**

(51) Int. Cl.³ : **G 03 F 7/20**

(21) Numéro de dépôt : **80401211.0**

(22) Date de dépôt : **25.08.80**

(54) **Procédé pour reporter sur un support l'ombre fidèle d'un masque percé de fentes distribuées périodiquement, et application de ce procédé notamment en photo-lithogravure.**

(30) Priorité : **10.09.79 FR 7922554**

(43) Date de publication de la demande :
**18.03.81 Bulletin 81/11**

(45) Mention de la délivrance du brevet :
**13.06.84 Bulletin 84/24**

(84) Etats contractants désignés :
**AT BE CH DE GB IT LI LU NL SE**

(56) Documents cités :
**DE-A- 1 572 195**
**DE-A- 2 037 590**
**FR-A- 2 062 602**
**FR-A- 2 132 043**
**FR-A- 2 356 975**
**GB-A- 2 011 645**
**US-A- 3 640 197**
**US-A- 3 697 178**
**IBM TECHNICAL DISCLOSURE BULLETIN vol. 19, no. 5, octobre 1976 New York US C. LAPADULA et al.: "Depolarizing and Profile-Manipulating conformable-Contact Printer", page 1928**

(73) Titulaire : **Roumiguières, Jean-Louis**
**69, Boulevard Desgranges**
**F-92330 Sceaux (FR)**

(72) Inventeur : **Roumiguieres, Jean-Louis**
**69 boulevard Desgranges**
**F-92330 Sceaux (FR)**
Inventeur : **Neviere, Michel**
**93 Chemin des Mourets**
**F-13013 Marseille (FR)**

(74) Mandataire : **Lemoine, Robert et al**
**Cabinet Malémont 42, Avenue du Président Wilson**
**F-75116 Paris (FR)**

## Description

La présente invention concerne un procédé pour obtenir sur un support une ombre portée reproduisant fidèlement un masque percé de fines fentes parallèles distribuées périodiquement, procédé dans lequel le masque est éclairé avec une onde plane monochromatique qui est polarisée perpendiculairement à son plan d'incidence de façon que le vecteur champ électrique soit parallèle aux fentes, procédé décrit dans le document DE-A-1 572 195.

On rencontre actuellement de très grandes difficultés pour reproduire fidèlement sur un support un masque percé de très fines fentes. Lorsqu'on éclaire un masque de ce type, il se produit en effet de nombreuses diffractions parasites qui empêchent la reproduction sur le support d'une ombre portée correspondant fidèlement au masque et ayant des contours parfaitement contrastés.

La présente invention se propose de remédier à ces inconvénients et, pour ce faire, elle a pour objet un procédé qui se caractérise en ce qu'il consiste à choisir la longueur d'onde de l'onde plane incidente pour qu'il n'existe que deux ordres diffractés pour chacun des deux demi-espaces qui sont situés de part et d'autre du plan moyen du masque, et à régler l'angle d'incidence de l'onde plane de telle sorte que l'ordre diffracté réfléchi qui n'est pas l'ordre spéculairement réfléchi se propage dans la direction de l'onde incidente mais en sens inverse.

Grâce à ces dispositions, les diffractions parasites sont maintenant supprimées, ce qui permet donc d'obtenir une ombre portée qui est la reproduction fidèle et parfaitement contrastée du masque.

Il est par ailleurs possible de placer le support à une distance raisonnable du masque et d'échapper ainsi aux contraintes et inconvénients résultant de la mise en contact de ces deux éléments.

Il convient encore de noter que le matériau constituant le masque peut être quelconque et que sa réflectivité peut descendre jusqu'à de faibles valeurs, pourvu que l'épaisseur du masque soit suffisante.

Selon une caractéristique particulière du procédé conforme à l'invention, les fentes du masque peuvent avoir en coupe une section droite arbitraire. Des essais de laboratoire ont en effet montré que la forme des parois des fentes n'a aucune influence sur la qualité de l'ombre portée obtenue sur le support. Le taillage des fentes n'a donc pas à être conduit de façon extrêmement rigoureuse, ce qui simplifie la fabrication du masque tout en la rendant moins onéreuse.

Lorsque le masque comporte des fentes distribuées périodiquement avec un pas d, le procédé conforme à l'invention propose l'utilisation d'une onde plane monochromatique dont la longueur d'onde est comprise entre environ 2 d/3 et environ 2 d.

Le procédé selon l'invention peut recevoir des applications industrielles très variées. Il peut par exemple être utilisé dans le domaine de la photolithographie, dans les techniques de fabrication des circuits intégrés pour l'électronique et l'optique intégrée, en particulier les circuits à couplage de charge, pour la réalisation de lignes de retard, la reproduction de réseaux de diffraction utilisés tant en réflexion qu'en transmission, la reproduction de coupleurs à réseau pour l'optique intégrée, etc.

Un mode d'exécution de la présente invention sera décrit ci-après en référence au dessin annexé dans lequel :

La figure 1 est une vue de dessus d'un masque reproductible fidèlement par la mise en œuvre du procédé selon l'invention ;

La figure 2 est une vue partielle en coupe et à échelle agrandie effectuée suivant la ligne II-II de la figure 1, l'une des fentes du masque étant représentée éclairée conformément aux enseignements du procédé selon l'invention ; et

La figure 3 est une vue partielle et à échelle agrandie semblable à la figure 2 et montrant l'ombre du masque reportée sur un support recouvert d'une couche photosensible.

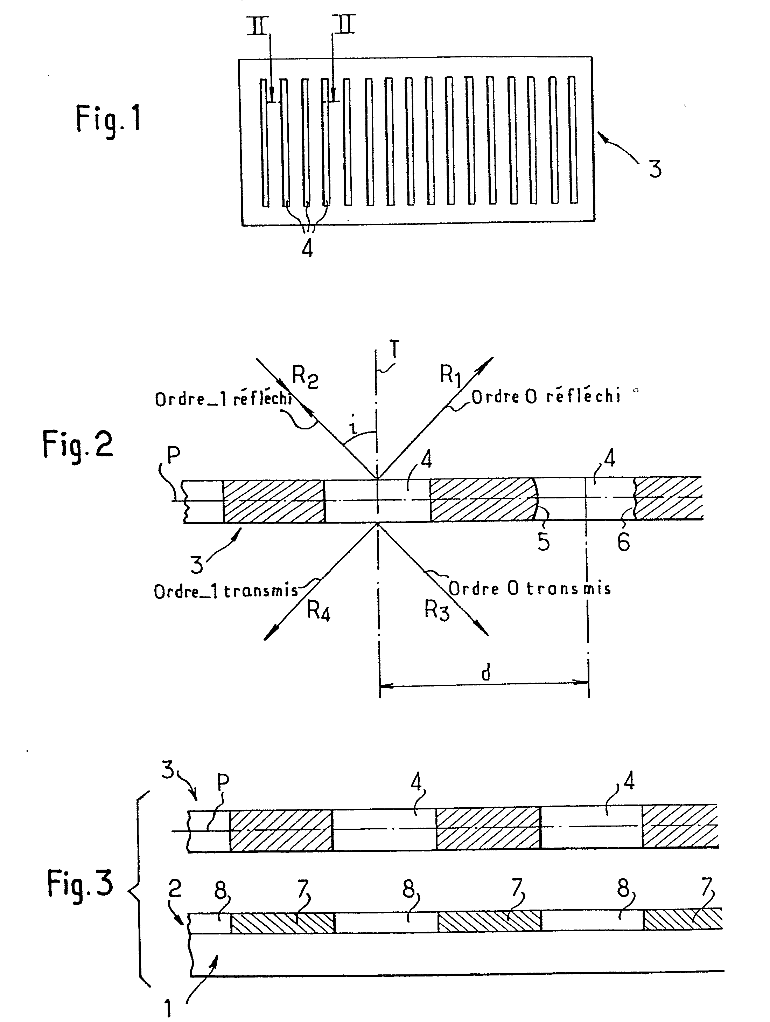

Le procédé conforme à l'invention a été mis au point en s'inspirant des montages dits de LITTROW ou de BRAGG pour obtenir sur un support 1, par exemple revêtu d'une couche photosensible 2, une ombre portée reproduisant fidèlement un masque 3 percé de fines fentes parallèles 4. Dans l'exemple représenté sur le dessin, les fentes 4 sont rectilignes et sont réalisées avec un pas constant d. En se référant en particulier à la figure 2, on remarquera que les parois de ces fentes peuvent avoir une forme quelconque pouvant par exemple être semblable à celle des parois désignées par les références 5 et 6.

Pour mettre en œuvre le procédé conforme à l'invention, on éclaire tout d'abord le masque 3 avec une onde plane monochromatique dont le plan d'incidence, qui correspond au plan du dessin de la figure 2, est perpendiculaire à la direction des fentes 4. Cette onde monochromatique est polarisée perpendiculairement à son plan d'incidence afin que son vecteur champ électrique soit parallèle aux fentes. Quant à sa longueur d'onde $\lambda$, elle est choisie en fonction du pas des fentes de façon à ce qu'il n'existe que deux ordres diffractés pour chacun des deux demi-espaces délimités par chaque fente et situés de part et d'autre du plan moyen P du masque. En se référant à la figure 2 pour laquelle cette condition est satisfaite, on remarquera qu'il n'existe effectivement que deux ordres diffractés réfléchis et deux ordres diffractés transmis, les deux ordres réfléchis étant symbolisés par les rayons $R_1$ et $R_2$ situés au-dessus du masque tandis que les deux ordres transmis sont symbolisés par les rayons $R_3$ et $R_4$ situés au-dessous du masque.

Après avoir choisi la longueur d'onde de l'onde plane monochromatique, on règle ensuite l'angle d'incidence i de telle sorte que l'ordre-1 réfléchi (symbolisé par le rayon $R_2$ et qui n'est pas l'ordre 0 spéculairement réfléchi, lequel est symbolisé par le rayon $R_1$) se propage dans la direction de l'onde incidente, mais en sens inverse. Par ce réglage, on obtient alors en transmission deux ondes planes, l'une d'ordre 0 (symbolisée par le rayon $R_3$) et l'autre d'ordre −1 (symbolisé par le rayon $R_4$). Ces deux ondes, qui sont de même amplitude et de même phase, se propagent dans des directions symétriques par rapport au plan T s'étendant perpendiculairement du plan moyen P.

Les ondes planes obtenues en transmission à la sortie de chaque fente interfèrent alors entre elles en générant sur le support 1 des zones obscures 7 et éclairées 8 reproduisant fidèlement le masque, et présentant un contraste maximum. Il convient de noter que l'ombre du masque est reportée sur le support avec une directivité parfaite même lorsque le masque et le support sont séparés l'un de l'autre.

Dans un montage de LITTROW, l'ordre-1 réfléchi dans l'air est obtenu lorsque :

$$2 \sin i = \lambda/d$$

c'est-à-dire lorsque :

$$\sin i = \lambda/2\,d \qquad (1)$$

Par ailleurs, on obtient deux ordres réfléchis dans l'air lorsque $3 \sin i > 1$, c'est-à-dire lorsque :

$$\sin i > 1/3 \qquad (2)$$

soit :

$$i > 19°28'$$

La détermination de la longueur d'onde $\lambda$ en fonction du pas des fentes du masque est obtenue à partir des formules (1) et (2). La première formule impose en effet que $\lambda/2\,d$ soit inférieur ou égal à 1, et donc que :

$$\lambda \leqslant 2\,d$$

En remplaçant maintenant $\sin i$ de la formule (2) par sa valeur donnée par la formule (1), on constate qu'il est également nécessaire que :

$$\lambda \geqslant 2\,d/3$$

Finalement, il est donc nécessaire que la longueur d'onde de l'onde plane monochromatique satisfasse à la relation :

$$2\,d/3 \leqslant \lambda \leqslant 2\,d \qquad (3)$$

Le procédé conforme à l'invention peut recevoir de très nombreuses applications industrielles. Il peut par exemple être utilisé pour impressionner une couche photosensible telle que la couche 2 visible sur la figure 3, mais il peut également être utilisé pour fabriquer des circuits intégrés, pour réaliser des lignes de retard et des circuits à couplage de charge (C.C.D.) ou pour reproduire des réseaux de diffraction et des coupleurs à réseau.

Ces applications de l'invention mettent en œuvre des techniques classiques, mais l'invention permet d'utiliser ces techniques pour la réalisation de produits dont le pas peut descendre jusqu'à moins de 0,2 microns, alors que jusqu'à présent on ne savait pas descendre pour un prix de revient raisonnable au-dessous de 1 ou 2 microns.

**Revendications**

1. Procédé pour obtenir sur un support une ombre portée reproduisant fidèlement un masque percé de fines fentes parallèles distribuées périodiquement, dans lequel le masque est éclairé avec une onde plane monochromatique qui est polarisée perpendiculairement à son plan d'incidence de façon que le vecteur champ électrique soit parallèle aux fentes, caractérisé en ce qu'il consiste à choisir la longueur d'onde de l'onde plane incidente pour qu'il n'existe que deux ordres diffractés pour chacun des deux demi-espaces qui sont situés de part et d'autre du plan moyen du masque, et à régler l'angle d'incidence de l'onde plane de telle sorte que l'ordre diffracté réfléchi qui n'est pas l'ordre spéculairement réfléchi se propage dans la direction de l'onde incidente mais en sens inverse.

2. Procédé selon la revendication 1 dans lequel le masque utilisé comporte des fentes distribuées périodiquement avec un pas désigné par d, caractérisé en ce qu'il consiste à utiliser une onde plane monochromatique dont la longueur d'onde est comprise entre environ 2 d/3 et environ 2 d.

**Claims**

1. A process for obtaining on a support medium a projected shadow faithfully reproducing a mask pierced with fine periodically distributed parallel slits, wherein the mask is illuminated with a flat monochromatic wave which is polarized perpendicularly to its plane of incidence so that the electric field vector is parallel to the slits, characterized in that it consists in choosing the wave length of the incident flat wave so that only two diffracted orders exist for each of the two half spaces which are situated on each side of the main plane of the mask, and adjusting the incidence angle of the flat wave so that the diffracted order reflected which is not the specularly reflected order is propagated in the direction of the incident wave but in the opposite sense.

2. A process according to claim 1, wherein the mask used comprises periodically distributed slits with a pitch designated by d, characterized in that it consists in using a flat monochromatic wave whose wave length is between about 2 d/3 and about 2 d.

## Ansprüche

1. Verfahren zur Erlangung eines Schlagschattens, der eine von periodisch verteilten, parallelen, feinen Spalten durchbrochene Maske getreu reproduziert, auf einem Träger, wobei die Maske mit einer ebenen, monochromatischen Welle beleuchtet wird, die senkrecht zu ihrer Einfallsebene so polarisiert ist, daß der Vektor des elektrischen Feldes zu den Spalten parallel ist, dadurch gekennzeichnet, daß es darin besteht, die Wellenlänge der einfallenden ebenen Welle so zu wählen, daß nur zwei Ordnungen der Beugung für jeden der beiden Halbräume, die einerseits und andererseits der mittleren Ebene der Maske liegen, existieren, und den Einfallswinkel der ebenen Welle so zu regeln, daß die reflektierte Beugungsordnung, die nicht die spiegelbildlich reflektierte Ordnung ist, sich in Richtung der einfallenden Welle, aber im umgekehrten Sinne, fortpflanzt.

2. Verfahren nach Anspruch 1, bei dem die verwendete Maske periodisch mit einer mit d bezeichneten Teilung verteilte Spalten aufweist, dadurch gekennzeichnet, daß es darin besteht, eine ebene, monochromatische Welle zu verwenden, deren Wellenlänge zwischen ungefähr 2 d/3 und ungefähr 2 d ist.

Fig.1

II II

3

4

Fig.2

T

R$_2$ R$_1$

Ordre_1 réfléchi Ordre 0 réfléchi

i

P 4 4

3 5 6

Ordre_1 transmis Ordre 0 transmis

R$_4$ R$_3$

d

Fig.3

3 P 4 4

2 8 7 8 7 8 7

1